# EUROPEAN PATENT APPLICATION

(11) **EP 4 738 062 A1**
(43) Date of publication of application: **06.05.2026**
(21) Application number: 25197146.1
(22) Date of filing: 20.08.2025
(51) Int. Cl.: G06F 1/20, G06F 1/16, G06F 1/18, G02F 1/1333, G09G 3/00, H05K 7/20, H10K 59/80

(54) **DISPLAY DEVICE WITH IMPROVED HEAT RADIATION**

(30) Priority: 29.10.2024 KR 20240149182
(71) Applicant: LG Display Co., Ltd., Seoul 07336 (KR)
(72) Inventor: JIN, Sang-Woo, Paju-si 10845 (KR); MYUNG, Noh-Jin, Paju-si 10845 (KR)
(74) Representative: Cousens, Nico

(57) **Abstract**

A display device includes a first type heat dissipation layer having a high emissivity disposed on a lower surface of a display panel, an upper surface of an inner plate and/or a lower surface of the inner plate facing to a lower frame, and a second type heat dissipation layer having a lower emissivity disposed on the lower surface of the inner plate corresponding to a driving circuit board. The heat generated in the display panel can be efficiently dissipated to an outside and heat generated in the driving circuit board can be minimized from being transferred to the display panel.

## Description

### CROSS-REFERENCE TO RELATED APPLICATION

This application claims priority to the Republic of Korea Patent Application No. 10-2024-0149182, filed on October 29, 2024.

### BACKGROUND

### Technical Field

The present disclosure relates to a display device, and more particularly to, a display device with beneficial heat dissipation property, luminous lifespan, and durability.

### Discussion of Related Art

As large-area display devices have been developed, demands for flat display devices with small space occupancy has been increasing. As one of the flat display devices, technologies of light-emitting display devices including a light-emitting diode has been developing rapidly. The light-emitting display device can be divided into an organic light-emitting display device using organic light-emitting materials and an inorganic light-emitting display device using inorganic luminous materials.

The light-emitting display device includes a display panel implementing images and a driving circuit board providing various signals to the display panel. When the light-emitting display device is operated, it is necessary to release heat generated from the display panel and the driving circuit board to the outside. A method of introducing a hole structure to release heat generated from the display panel to outside of the display device, or placing a heat dissipation member with excellent heat conductivity on a lower surface of the display panel or on an upper surface and a lower surface of the driving circuit board has been proposed.

However, simply introducing a heat dissipation member or a hole structure does not efficiently release the heat generated from the light-emitting display device to the outside. Since the heat generated during the driving process is not released to the outside, the materials included in the display panel deteriorate or the performance of the components included in the driving circuit board deteriorate. As a result, the image quality of the light-emitting display device deteriorates and durability of the device decreases.

### SUMMARY

Accordingly, some embodiments of the present disclosure are directed to a display device that substantially obviates one or more of the problems due to the limitations and disadvantages of the related art.

An embodiment of the present disclosure is to provide a display device that can release efficiently heat generated in the course of driving process to the outside.

Another embodiment of the present disclosure is to provide a display device that can improve an image quality and durability by minimizing or at least reducing deterioration of the luminous materials and components.

Additional features and aspects will be set forth in the description that follows, and in part will be apparent from the description, or can be learned by practice of the disclosed concepts provided herein. Other features and aspects of the disclosed concept can be realized and attained by the structure particularly pointed out in the written description, or derivable therefrom, and the claims as well as the appended drawings.

To achieve these and other embodiments of the inventive concepts, as embodied and broadly described, the present disclosure provides a display device that comprises: a display panel including a first surface at which an image is displayed and a second surface that is opposite the first surface; an inner plate including a first surface that is spaced apart from the second surface of the display panel and a second surface; a lower frame that is spaced apart from the second surface of the inner plate; a driving circuit board that is between the second surface of the inner plate and the lower frame; a first heat dissipation layer on the second surface of the display panel; a second heat dissipation layer on the first surface of the inner plate such that the second heat dissipation layer is between the first heat dissipation layer and the first surface of the inner plate; and a third heat dissipation layer disposed on the second surface of the inner plate, wherein the third heat dissipation layer includes a first area heat dissipation layer that overlaps the driving circuit board and a second area heat dissipation layer that is non-overlapping with the driving circuit board, wherein each of the first heat dissipation layer, the second heat dissipation layer, and the second area heat dissipation layer each includes a material having an emissivity between 0.8 and less than 1, and wherein the first area heat dissipation layer includes a material having an emissivity between 0.2 and 0.5.

In one embodiment, a display device comprises: a display panel including a first surface at which an image is displayed and a second surface that is opposite the first surface; a plate including a first surface that is spaced apart from the second surface of the display panel by a first airgap and a second surface; a frame that is spaced apart from the second surface of the plate; a driving circuit board that is between the second surface of the plate and the frame; a first heat dissipation layer in contact with the second surface of the display panel; and a second heat dissipation layer in contact with the first surface of the plate such that the first airgap is between the first heat dissipation layer and the second heat dissipation layer, wherein an emissivity of the first heat dissipation layer and an emissivity of the second heat dissipation layer are greater than an emissivity of the display panel and an emissivity of the plate.

The lower surface of the display panel and the upper surface of the inner plate are faced with two heat dissipation layers with a high emissivity. As the display device is driven, the heat generated in the display panel can be release to the outside via the inner plate.

On the other hand, the heat dissipation layer with a relatively low emissivity is disposed on the first lower surface of the inner plate corresponding to the driving circuit board. It is possible to transfer the heat generated from the driving circuit board to the display panel via the inner plate in a minimized form.

In addition, the second lower surface of the inner plate and the upper surface of the lower frame are faced with two heat dissipation layers with a high emissivity. The heat generated in the display panel can be released rapidly to the outside via the inner plate and the lower frame.

In some embodiments, a corrugated or irregular structure with a plurality of convex portions and a plurality of concave portions are located on the upper surface of the inner plate and/or the upper surface of the lower frame so as to increase a heat transfer area. As the amount of thermal radiation toward the lower surface increases and the amount of thermal extraction to the outside increases, it is possible to implement additional cooling effect.

In some embodiments, another heat dissipation layer is disposed on the lower surface of the lower frame. As the outer visible light is reflected and the infrared light is released to the outside, it is possible to minimize or at least reduce the heat transfer to the display device.

The deterioration of the luminous materials and/or the functional deterioration of the circuit components caused by the heat during the driving process can be prevented. Accordingly, it is possible to implement a display device with lower power consumption, long emission lifespan and beneficial durability.

It is to be understood that both the foregoing general description and the following detailed description are exemplary and explanatory, and are intended to provide further explanation of the inventive concepts as claimed.

### BRIEF DESCRIPTION OF THE DRAWINGS

The accompanying drawings, which provide a further understanding of the disclosure, are incorporated in and constitute a part of this application, illustrate embodiments of the disclosure and together with the description serve to explain principles of the disclosure.
FIG. 1 illustrates a schematic exploded perspective view in accordance with an embodiment of the present disclosure.
FIG. 2 illustrates a schematic circuit diagram of a display panel in the display device in accordance with an embodiment of the present disclosure.
FIG. 3 illustrates a schematic cross-sectional view of the display panel in the display device in accordance with an embodiment of the present disclosure.
FIG. 4 illustrates a schematic cross-sectional view of the display device in accordance with a first embodiment of the present disclosure.
FIG. 5 is a schematic diagram illustrating that heat generated when the display device is driven is released toward the outside in accordance with the first embodiment of the present disclosure.
FIG. 6 illustrates a schematic cross-sectional view of the display device in accordance with a second embodiment of the present disclosure.
FIG. 7 is a schematic diagram illustrating that heat generated when the display device is driven is released toward the outside in accordance with the second embodiment of the present disclosure.
FIG. 8 illustrates a schematic cross-sectional view of the display device in accordance with a third embodiment of the present disclosure.
FIG. 9 illustrates a schematic cross-sectional view of the display device in accordance with a fourth embodiment of the present disclosure.
FIG. 10 illustrates a schematic cross-sectional view of the display device in accordance with a fifth embodiment of the present disclosure.
FIG. 11 is a graph showing that heat energy in the form of radiation is transferred, thereby improving cooling efficiency when a heat dissipation layer with a high emissivity is arranged on the lower surface of the display panel, the upper surface and the lower surface of the inner plate, and the upper surface of the lower frame, respectively, in accordance with an embodiment of the present disclosure.
FIG. 12 is a graph showing that cooling efficiency is further improved when a heat dissipation layer with a high emissivity is arranged on the lower surface of the display panel, the upper surface and the lower surface of the inner plate, and the upper surface of the lower frame, respectively, and an irregular pattern is applied to the upper surface of the inner plate and/or the upper surface of the lower frame in accordance with another embodiment of the present disclosure.

### DETAILED DESCRIPTION

Advantages and features of the present disclosure and methods for achieving them will be made clear from embodiments described in detail below with reference to the accompanying drawings. The present disclosure can, however, be implemented in many different forms and should not be construed as being limited to the embodiments set forth herein, and the embodiments are provided such that this disclosure will be thorough and complete and will fully convey the scope of the present disclosure to those skilled in the art to which the present disclosure pertains.

Shapes, sizes, ratios, angles, numbers, and the like disclosed in the drawings for describing embodiments of the present disclosure are merely illustrative examples, and thus the present disclosure is not limited to the illustrated examples. The same reference numerals refer to the same components throughout this disclosure unless otherwise specified. Further, in the following description of the present disclosure, where a detailed description of a known related art may unnecessarily obscure the gist of the present disclosure, the detailed description thereof may be omitted herein or may be briefly discussed.

Where terms such as "including," "having," "comprising," and the like are used in this disclosure, other parts can be added unless a more limiting term like "only" is used herein. Further, where a component is expressed as being singular, being plural is included, and vice versa, unless otherwise specified.

In analyzing a component, an error range should be interpreted as being included even where there is no explicit description.

In describing a positional relationship, for example, where a positional relationship of two parts/layers is described as being "over," "on," "above," "below," "under," "next to," or the like, one or more other parts/layers can be provided between the two parts/layers, unless a more limiting term like "immediately" or "directly" is used therewith.

In describing a temporal relationship, for example, where a temporal predecessor relationship is described as being "after," "subsequent," "next to," "prior to," or the like, unless a more limiting term like "immediately" or "directly" is used, cases that are not continuous or sequential can also be included

Although the terms first, second, and the like may be used to describe various components, these components are not substantially limited by these terms. These terms are used only to refer to one component separately from another component and may not define any particular order or sequence. Therefore, a first component described below can substantially be a second component, and vice versa, within the scope of the present disclosure.

In describing components of the present disclosure, terms such as first, second, A, B, (a), (b), etc. may be used. These terms are only intended to distinguish the components from other components, and the nature, order, sequence, or numbers of the components are not limited by the terms. When it is described that a component is "connected," "coupled," or "engaged" to another component, it should be understood that the component may be directly connected or connected to the other component, but that other components may also be "interposed" between each component, or that each component may be "connected," "coupled," or "engaged" through another component.

Features of various embodiments of the present disclosure can be partially or entirely united or combined with each other, technically various interlocking and driving are possible, and each of the embodiments can be independently implemented with respect to each other or implemented together in a co-dependent relationship.

All the components of each display apparatus according to all embodiments of the present disclosure are operatively coupled and configured.

As used herein, 'display apparatus' or 'display device" can comprise a narrowly defined display apparatus such as a display module including a display panel and a driving unit for driving the display panel. In addition, the display apparatus can also include a set electronic device or a set apparatus such as a notebook computer, a television, a computer monitor, an automotive display, or other forms of a vehicle, which are complete products (or final products) including a display module, an equipment display, a mobile electronic device such as a smart phone or an electronic pad, and the like.

Therefore, the display apparatus in the present disclosure can include a narrowly defined display apparatus itself such as a display module, and a set apparatus which is an application product or a final consumer device including a display module.

Reference will now be made in detail to aspects of the disclosure, examples of which are illustrated in the accompanying drawings. Wherever possible, the same reference numbers will be used throughout the drawings to refer to the same or like parts.

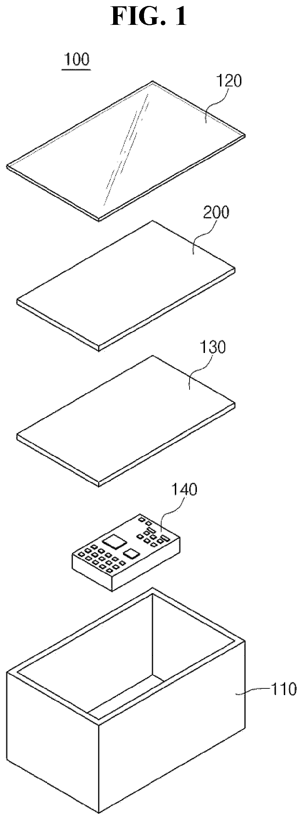

FIG. 1 illustrates a schematic exploded perspective view in accordance with an embodiment of the present disclosure.

As illustrated in FIG. 1, a display device 100 such as a light-emitting display device in accordance with the present disclosure can comprise a lower frame 110, a cover window 120 located on the opposite side of the lower frame 110, a display panel 200, an inner plate 130, and a driving circuit board 140 disposed sequentially between the lower frame 110 and the cover window 120.

In one embodiment, an air gap can be formed between the cover window 120 and the display panel 200, between the display panel 200 and the inner plate 130, between the inner plate 130 and the driving circuit board 140, and/or between the driving circuit board 140 and the lower frame 110, respectively. Those components or members can be connected or linked to each other using engaging means such as an adhesive and/or a foam tape.

In some embodiments, any one of the adhesive, a tape member, and an adhesive sheet may be interposed between the inner plate 130 and the lower frame 110. For example, an adhesive such an epoxy-containing adhesive, an acrylate-containing adhesive and/or a urethanecontaining adhesive may be applied when combining the inner plate 130 and the lower frame 110, or an adhesive may be laminated in advance on the lower surface of the inner plate 130 or the upper surface of the lower frame 110, and then these members may be processed to be combined.

The lower frame 110 may be a cover bottom or a back plate. The lower frame 110 positioned at the rear of the inner plate 130 and/or the driving circuit board 140 has an internal space so that the lower frame 110 can accommodate the display panel 200, the inner plate 130 and the driving circuit board 140. Alternatively, the lower frame 110 can cover at least a part of the sides of the display panel 200 and the inner plate 130.

In one embodiment, the lower frame 110 can comprise a metal material or component. In another embodiment, the lower frame 110 can comprise a fiber so that the lower frame 110 can have a beneficial rigidity. For example, the lower frame 110 can comprise, but is not limited to, at least one of a glass fiber, a carbon fiber, a metallic wire, and a metallic fiber.

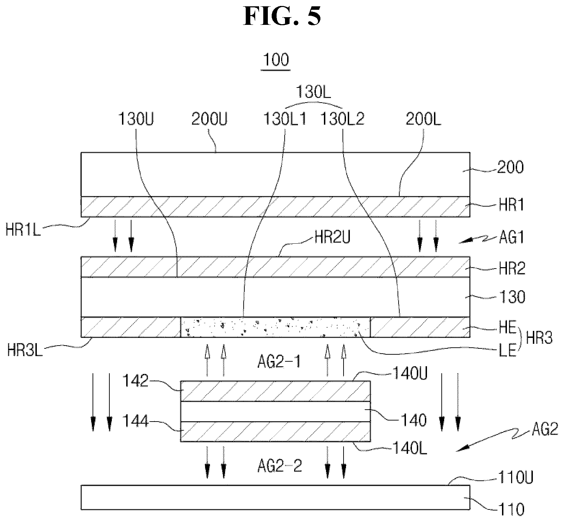

The cover window 120 constitutes an outer periphery of the display device 100. The cover window 120 is located on a first surface of the display panel 200 (e.g., an upper surface) where the image is displayed on the display panel 200 and transmits the image of the display panel 200 while protecting the display panel 200 from external impact or stress. For example, the cover window 120 can be disposed on an upper surface 200U of the display panel 200 as shown in FIG. 5.

The cover window 120 can include a reinforced glass or a reinforce plastics. For example, the cover window 120 can comprise, but is not limited to, a material selected from high-strength reinforced glass, polyethylene terephthalate (PET), an acrylic resin such as polymethyl methacrylate (PMMA) and (meth)acrylate-containing resins to prevent scratches from the outside. The cover window 120 may be injection-molded using an in mold lamination method or a co-extrusion method using those materials. When flexible properties are required in the display device 100, the cover window 120 can be manufactured from a plastic material.

The inner plate 130 (e.g., a plate) can be positioned under the display panel 200 such that the display panel 200 is between the cover window 120 and the inner plate 130. The size or dimension of the inner plate 130 can be smaller than the size or dimension of the display panel 200. The inner plate 130 may have an upper surface (e.g., a first surface) that is spaced apart from the lower surface of the display panel 200 by the air gap AG1 and a lower surface (e.g., a second surface) that is opposite the first surface of the inner plate 130.

In another embodiment, the inner plate 130 can comprise a ferromagnetic material and/or a paramagnetic material. In this case, the inner plate 130 can provide rigidity to the display panel 200. The inner plate 130 can release heat generate in the display panel 200 to the outside.

The inner plate 130 has high heat dissipation properties and can comprise a metal component. For example, the inner plate 130 can comprise aluminum and/or an aluminum alloy. In another embodiment, the inner plate 130 can be configured to include at least one of copper (Cu), silver (Ag), nickel (Ni) and tungsten (W), or can be formed of a heat-dissipating metal plate having an outer surface plated with at least one of nickel (Ni), silver (Ag) and gold (Au).

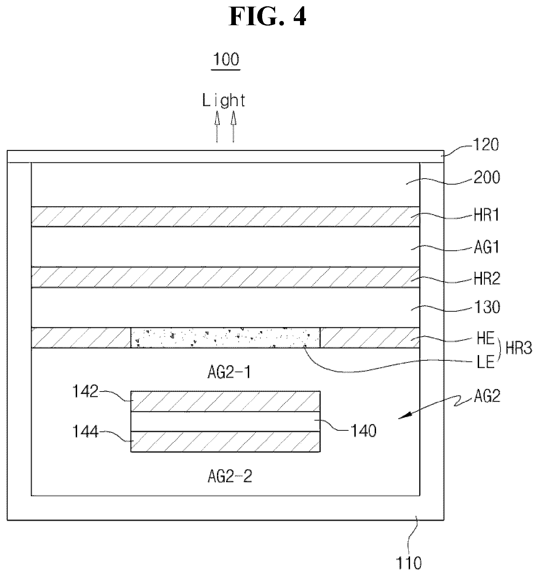

The driving circuit board 140 can be disposed on a lower surface 130L of the inner plate 130 such that the driving circuit board 140 is between the inner plate 130 and the lower frame 110. For example, the driving circuit board 140 can be disposed correspondingly on a first lower surface 130L1 of the inner plate 130. The inner plate 130 and the driving circuit board 140 are spaced part such that a third air-gap AG2-1 (FIG. 4) is formed between the inner plate 130 and the driving circuit board 140. The third air gap AG2-1 may act as an insulating layer that does not transfer heat emitted from the driving circuit board 140 to the display panel 200.

As an example, the driving circuit board 140 can comprise circuit component such as a timing controller. However, the configuration of the driving circuit board 140 is not limited thereto and may include various circuit components generating signals for deriving the display panel 200.

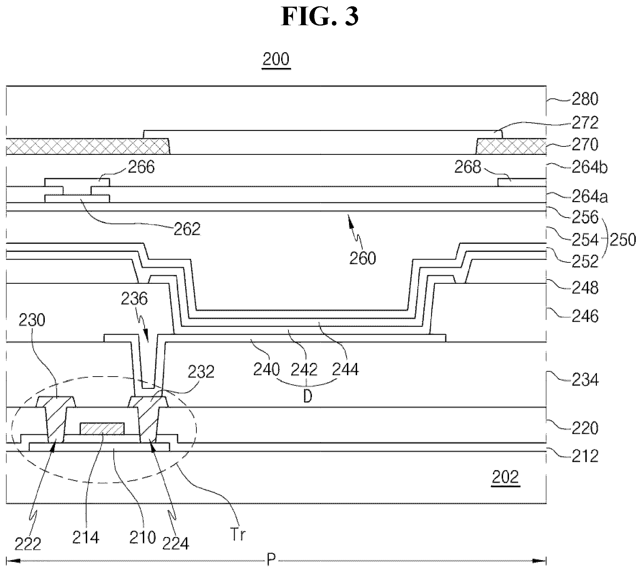

The display panel 200 can be modularized with its edges surrounded by the lower frame 100 and the cover window 120 is arranged on the upper surface 200U of the display panel 200. The display panel 200 may include a substrate 202 (FIG. 3), a light-emitting diode (D, FIG. 3), and optionally, a color filter layer 272 (FIG. 3) and/or a thin film transistor Tr (FIG. 3).

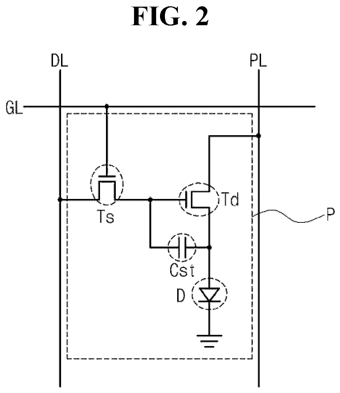

The display panel 200 of the display device 100 will be described in more detail. FIG. 2 illustrates a schematic circuit diagram of a display panel in the display device in accordance with the present disclosure.

As illustrated in FIG. 2, the display panel 200 includes a gate line GL, a data line DL, and a power line PL spaced apart parallel to the data line DL or the gate line GL crossing each other to define the pixel region P. A switching thin film transistor Ts, a driving thin film transistor Td, a storage capacitor Cst, and a light-emitting diode D can be disposed in the pixel region P. The pixel region P can include a red sub-pixel, a green sub-pixel, a blue sub-pixel and/or a white sub-pixel.

The switching thin film transistor Ts is connected to the gate line GL and the data line DL. The driving thin film transistor Td and the storage capacitor Cst are connected between the switching thin film transistor Ts and the power line PL, and the light-emitting diode D is connected to the driving thin film transistor Td.

In the display device 100 or the display panel 200, when the switching thin film transistor Ts is turned on by a gate signal applied to the gate line GL, a data signal applied to the data line DL is applied a gate electrode 214 (FIG. 3) and one electrode of the storage capacitor Cst through the switching thin film transistor Ts.

The driving thin film transistor Td is turned on by the data signal applied to the gate electrode 214 so that a current proportional to the data signal is supplied from the power line PL to the light-emitting diode D through the driving thin film transistor Td. And then, the light-emitting diode D emits light having a luminance proportional to the current flowing through the driving thin film transistor Td. In this case, the storage capacitor Cst is charged with a voltage proportional to the data signal so that the voltage of the gate electrode 214 in the driving thin film transistor Td is kept constant during one frame. Therefore, the display device 100 can display a desired image.

FIG. 3 illustrates a schematic cross-sectional view of the display panel in the display device in accordance with the present disclosure.

As illustrated in FIG. 3, the display panel 200 includes a substrate 202 and a light-emitting diode D disposed on the substrate 202, and optionally a thin film transistor Tr disposed on the substrate 202 and a color filter layer 272 disposed on the light-emitting diode D.

The substrate 202 defines the pixel region P including the red sub-pixel, the green sub-pixel and the blue sub-pixel. Alternatively or additionally, the pixel region P can further comprise the white sub-pixel. The substrate 202 can be a glass substrate and/or a flexible substrate. For example, the substrate 202 can be one of, but is not limited to, a polyimide (PI) substrate, a polyethersulfone (PS) substrate, a polyethylene naphthalate (PEN) substrate, a polyethylene terephthalate (PET) substrate, a polycarbonate (PC) substrate.

The thin film transistor Tr is disposed on the substrate 202. In FIG. 3, the thin film transistor Tr is disposed directly on the substrate 202. Alternatively, a buffer layer is disposed on the substrate 202, and the thin film transistor Tr can be disposed on the buffer layer. For example, the buffer layer can comprise, but is not limited to, inorganic insulating material such as silicon oxide (SiOₓ, wherein 0 < x ≤ 2), silicon nitride (SiNₓ, wherein 0 < x ≤ 2), and the likes.

The thin film transistor Tr can comprise a semiconductor layer 210, a gate electrode 214, a source electrode 230, and a drain electrode 232. The thin film transistor Tr can be a driving thin film transistor Td (FIG. 2).

The semiconductor layer 210 is disposed on the substrate 202. In one embodiment, the semiconductor layer 210 can comprise oxide semiconductor materials. The oxide semiconductor material can comprise, but is not limited to, zinc oxide (ZnO), indium-zinc oxide (IZO), indiumaluminum-zinc oxide (IAZO), indium-gallium-zinc oxide (IGZO) and/or indium-tin-zinc oxide (ITZO).

When the semiconductor layer 210 includes the oxide semiconductor material, a light-shield pattern can be disposed under the semiconductor layer 210. The light-shield pattern can prevent light from being incident toward the semiconductor layer 210, and thereby, preventing or reducing the semiconductor layer 210 from being degraded by the light.

In another embodiment, the semiconductor layer 210 can comprise polycrystalline silicon. In this case, opposite edges of the semiconductor layer 210 can be doped with impurities.

A gate insulating layer 212 comprising an insulating material is disposed on the semiconductor layer 210 on the entire substrate 202. The gate insulating layer 212 can comprise, but is not limited to, an inorganic insulating material such as silicon oxide (SiOₓ, wherein 0 < x ≤ 2) or silicon nitride (SiNₓ, wherein 0 < x ≤ 2).

The gate electrode 214 made of a conductive material such as a metal component is disposed on the gate insulating layer 212 so as to correspond to a center of the semiconductor layer 210 in one embodiment. For example, the gate electrode 214 can comprise, but is not limited to, metal such as copper (Cu), molybdenum (Mo), titanium (Ti), aluminum (Al), gold (Au) and/or silver (Ag). The gate electrode 214 can have a single-layer structure or a multiple-layer structure.

While the gate insulating layer 212 is disposed on the entire area of the substrate 202 in FIG. 3, the gate insulating layer 212 can be patterned identically as the gate electrode 214.

An interlayer insulating layer 220 comprising an insulating material is disposed on the gate electrode 214 and covers an entire surface of the substrate 202. For example, the interlayer insulating layer 220 can comprise, but is not limited to, an inorganic insulating material such as silicon oxide (SiOₓ, wherein 0 < x ≤ 2) or silicon nitride (SiNₓ, wherein 0 < x ≤ 2), or an organic insulating material such as benzocyclobutene or photo-acryl. The interlayer insulating layer 220 can have a single-layer structure or a multi-layer structure.

The interlayer insulating layer 220 has first and second semiconductor layer contact holes 222 and 224 that expose or do not cover a portion of the surface nearer to the opposing ends than to a center of the semiconductor layer 210. The first and second semiconductor layer contact holes 222 and 224 are disposed on opposite sides of the gate electrode 214 and spaced apart from the gate electrode 214. The first and second semiconductor layer contact holes 222 and 224 are formed within the gate insulating layer 212 and the interlayer insulating layer 220 in FIG. 3. Alternatively, in certain embodiments, the first and second semiconductor layer contact holes 222 and 224 can be formed only within the interlayer insulating layer 220 when the gate insulating layer 212 is patterned identically as the gate electrode 214.

A source electrode 230 and a drain electrode 232, which are made of conductive material such as a metal, are disposed on the interlayer insulating layer 220. The source electrode 230 and the drain electrode 232 are spaced apart from each other on opposing sides of the gate electrode 214, and contact both sides of the semiconductor layer 210 through the first and second semiconductor layer contact holes 222 and 224, respectively.

For example, each of the source electrode 230 and the drain electrode 232 can comprise, but is not limited to, a metal component such as copper (Cu), molybdenum (Mo), titanium (Ti), aluminum (Al), gold (Au) and/or silver (Ag). Each of the source electrode 230 and the drain electrode 234 can have a single-layer structure or a multi-layer structure.

The semiconductor layer 210, the gate electrode 214, the source electrode 230 and the drain electrode 232 constitute the thin film transistor Tr, which acts as a driving element. The thin film transistor Tr in FIG. 3 has a coplanar structure in which the gate electrode 214, the source electrode 230 and the drain electrode 234 are disposed on the semiconductor layer 210. Alternatively, the thin film transistor Tr can have an inverted staggered structure in which a gate electrode is disposed under a semiconductor layer and a source and drain electrodes are disposed on the semiconductor layer. In this case, the semiconductor layer can comprise amorphous silicon.

A passivation layer 234 is disposed on the source electrode 230 and the drain electrode 232. The passivation layer 234 covers the thin film transistor Tr on the entire substrate 202. The passivation layer 234 has a flat top surface and a drain contact hole (or a contact hole) 236 that exposes or does not cover the drain electrode 232 of the thin film transistor Tr. For example, the passivation layer 234 can comprise, but is not limited to, an inorganic insulating material such as silicon oxide (SiOₓ, wherein 0 < x ≤ 2) or silicon nitride (SiNₓ, wherein 0 < x ≤ 2), or an organic insulating material such as benzocyclobutene or photo-acryl.

The light-emitting diode D is disposed on the passivation layer 234. The light-emitting diode D comprises a first electrode 240 that is disposed on the passivation layer 234 and connected to the drain electrode 232 of the thin film transistor Tr. The light-emitting diode D further comprises an emissive layer 242 and a second electrode 244 each of which is disposed sequentially on the first electrode 240. The light-emitting diode D can be disposed in each of the red sub-pixel, the green sub-pixel and the blue sub-pixel, and can emit red color light, green color light and blue color light, respectively.

One of the first electrode 240 and the second electrode 244 can be an anode, and the other of the first electrode 240 and the second electrode 244 can be a cathode. One of the first electrode 240 and the second electrode 244 can be a reflective electrode, and the other of the first electrode 240 and the second electrode 244 can be a transmissive electrode.

The first electrode 240 is disposed separately in each pixel region P. In one embodiment, the first electrode 240 can be an anode and comprise conductive material having relatively high work function value, for example, a transparent conductive oxide (TCO). For example, the first electrode 240 can comprise, but is not limited to, indium-tin-oxide (ITO), indium-zinc-oxide (IZO), indium-tin-zinc-oxide (ITZO), tin oxide (SnO), zinc oxide (ZnO), indium-copper-oxide (ICO) and/or aluminum: zinc oxide (Al: ZnO; AZO).

The first electrode 240 can have a single-layer structure of the transparent conductive oxide. In another embodiment, the first electrode 240 can further comprise a reflective layer so that the first electrode 240 can have a double-layer or a triple-layer structure. The first electrode 240 can be a reflective electrode.

For example, the reflective layer can comprise, but is not limited to, silver (Ag) or an alloy of silver (Ag), and at least one of palladium (Pd), copper (Cu), indium (In) and neodymium (Nd), aluminum-palladium-copper (APC) alloy. As an example, the first electrode 240 can have, but is not limited to, a double-layer structure of Ag/ITO or APC/ITO, or a triple-layer structure of ITO/Ag/ITO or ITO/APC/ITO.

In addition, a bank layer 246 is disposed on the passivation layer 234 in order to cover edges of the first electrode 240. The bank layer 246 exposes or does not cover a center of the first electrode 240 corresponding to the pixel region P. A spacer 248 can be disposed on the bank layer 246. The bank layer 246 and the spacer 248 can comprise the same material. For example, each of the bank layer 246 and the spacer 248 can comprise, but is not limited to, a light-shielding or light-absorbing material.

An emissive layer 242 is disposed on the first electrode 240. In one embodiment, the emissive layer 242 can have a single-layer structure of an emitting material layer (EML). The EML can comprise organic light-emitting materials or inorganic luminescent materials. The display device 100 of the present disclosure can comprise, but is not limited to, an organic light-emitting display device or an inorganic light-emitting display device.

In the organic light-emitting display device, the EML can comprise a host and a dopant as an emitter. In the red sub-pixel, the EML can comprise a red host and a red dopant. In the green sub-pixel, the EML can comprise a green host and a green dopant. In the blue sub-pixel, the EML can comprise a blue host and a blue dopant. In the inorganic light emitting display device, the EML can comprise luminescent particles such as quantum dots (QDs) and quantum rods (QRs).

In another embodiment, the emissive layer 242 can have a multiple-layer structure. For example, the emissive layer 242 can further comprise at least one of a hole injection layer (HIL), a hole transport layer (HTL), an electron blocking layer (EBL) disposed sequentially between the first electrode 242 and the EML, and/or a hole blocking layer (HBL), an electron transport layer (ETL), an electron injection layer (EIL) disposed between the EML and the second electrode 244.

In one embodiment, the light-emitting diode D can emit white color in each of the red sub-pixel, the green sub-pixel and the blue sub-pixel. For example, the emissive layer 242 of the light-emitting diode D can comprise a first emitting part including a first emitting material layer, a second emitting part including a second emitting material layer and a charge generation layer (CGL) disposed between the first emitting part and the second emitting part so that the emissive layer 242 can have a double-stack structure. In this case, one of the first emitting material layer and the second emitting material layer can be a blue emitting material layer, and the other of the first emitting material layer and the second emitting material layer can be a yellow-green emitting material layer, or can comprise a red emitting material layer and a green emitting material layer.

In another embodiment, the emissive layer 242 of the light-emitting diode D can further comprise a third emitting part including a third emitting material layer and a second charge generation layer disposed between the second emitting part and the third emitting part so that the emissive layer 242 can have a triple-stack structure. In this case, the third emitting material layer can be a blue emitting material layer.

The second electrode 244 is disposed on the substrate 202 above which the emissive layer 242 is disposed. The second electrode 244 can be disposed on an emission area. The second electrode 244 can comprise a conductive material with a relatively low work function value compared to the first electrode 240 so that the second electrode 244 can act as a cathode. For example, the second electrode 244 can comprise, but is not limited to, aluminum (Al), magnesium (Mg), calcium (Ca), silver (Ag), and/or alloys thereof, for example, magnesiumsilver alloy (Mg: Ag). The second electrode 240 is thin so as to have light-transmissive (semitransmissive) property.

In addition, an encapsulation layer or an encapsulation film 250 is disposed on the second electrode 244 in order to prevent or reduce outer moisture from penetrating into the light-emitting diode D. For example, the encapsulation layer 250 can have, but is not limited to, a lamination structure of a first inorganic insulating layer 252, an organic insulating layer 254, and a second inorganic insulating layer 256.

For example, each of the first inorganic insulating layer 252 and the second inorganic insulating layer 256 can comprise, but is not limited to, an inorganic insulating material such as silicon oxide (SiOₓ, wherein 0 < x ≤ 2) or silicon nitride (SiNₓ, wherein 0 < x ≤ 2). For example, the organic insulating layer 254 can comprise, but is not limited to, an organic insulating material such as an epoxy resin, photo-acryl and/or photosensitive acrylic polymer.

The organic insulating layer 254 is disposed between the first inorganic insulating layer 252 and the second inorganic insulating material 256. The organic insulating layer 254 makes a bottom step flat and provides a flat surface.

A touch sensor 260 comprising a first touch electrode 266 and a second touch electrode 268 can be disposed on the encapsulation layer 250. For example, a connection electrode or a bridge electrode 262 can be disposed on the encapsulation layer 250, a first insulating material layer 264a with first and second contact holes exposing both sides of the connection electrode 262 can be disposed on the connection electrode 262, and the first touch electrode 266 and the second touch electrode 268 can be disposed on the first insulating material layer 264a.

The first touch electrodes 266 disposed adjacently can contact to the connection electrode 262 through the first and second contact holes to be connected electrically to each other. For example, the first insulating material layer 264a can comprise, but is not limited to, an inorganic insulating material such as silicon oxide (SiOₓ, wherein 0 < x ≤ 2) or silicon nitride (SiNₓ, wherein 0 < x ≤ 2).

A buffer layer can be disposed between the second inorganic insulating layer 256 of the encapsulation layer 250 and the first insulating material layer 264a. For example, the buffer layer can comprise, but is not limited to, an inorganic insulating material such as silicon oxide (SiOₓ, wherein 0 < x ≤ 2) or silicon nitride (SiNₓ, wherein 0 < x ≤ 2).

A second insulating material layer 264b can be disposed on the first touch electrode 266 and the second touch electrode 268. For example, the second insulating material layer 264b can comprise, but is not limited to, an inorganic insulating material such as silicon oxide (SiOₓ, wherein 0 < x ≤ 2) or silicon nitride (SiNₓ, wherein 0 < x ≤ 2), or an organic insulating material such as benzocyclobutene or photo-acryls.

A black matrix 270 and a color filter layer 272 can be disposed on the second insulating material layer 264b. Alternatively, the touch sensor 260 comprising the connection electrode 262, the first insulating material layer 264a, the first touch electrode 266, the second touch electrode 268 and the second insulating material layer 264b can be omitted, and the black matrix 270 and the color filter layer 272 can be disposed on the encapsulation layer 250.

The black matrix 270 is disposed in a non-emission area of an edge of the pixel region P, and has an opening corresponding to the light-emitting diode D. For example, the black matrix 270 can comprise, but is not limited to, a light-shielding or light-absorbing material such as a black resin and/or carbon black.

The color filter layer 272 is disposed in the emission area corresponding to the opening of the black matrix 270. When the pixel region P comprises the red sub-pixel, the green sub-pixel and the blue sub-pixel, the color filter layer 272 can comprise a red color filter pattern corresponding to the red sub-pixel, a green color filter pattern corresponding to the green sub-pixel and a blue color filter pattern corresponding to the blue sub-pixel. The red color filter pattern can comprise at least one of a red dye and a red pigment, the green color filter pattern can comprise at least one of a green dye and a green pigment, and the blue color filter pattern can comprise at least one of a blue dye and a blue pigment.

A second passivation layer can be disposed on the second insulating material layer 264b, and the black matrix 270 and the color filter layer 272 can be disposed on the second passivation layer. The second passivation layer can comprise, but is not limited to, an inorganic insulating material such as silicon oxide (SiOₓ, wherein 0 < x ≤ 2) or silicon nitride (SiNₓ, wherein 0 < x ≤ 2).

A first insulating layer 280 can be disposed on the color filter layer 272 and the black matrix 270. For example, the first insulating layer 280 can comprise, but is not limited to, an organic insulating material such as epoxy resin and/or photo-acryls. Alternatively, a second insulating layer can be disposed on the first insulating layer 280.

The display device in which a plurality heat dissipation layers are arranged is described in more detail.

FIG. 4 illustrates a schematic cross-sectional view of the display device in accordance with a first embodiment of the present disclosure. FIG. 5 is a schematic diagram illustrating that heat generated when the display device is driven is released toward the outside in accordance with the first embodiment of the present disclosure.

As illustrated in FIGS. 4 and 5, a first heat dissipation layer HR1 is positioned on a lower surface 200L (e.g., a second surface) of the display panel 200 and a second heat dissipation layer HR2 is positioned on an upper surface 130U (e.g., a first surface) of the inner plate 130. For example, the first heat dissipation layer HR1 is in contact with (e.g., direct contact) the lower surface 200L of the display panel 200 and the second heat dissipation layer HR2 is in contact with (e.g., direct contact) the upper surface 130U of the inner plate 130. A lower surface HR1L of the first heat dissipation layer HR1 positioned on the lower surface 200L of the display panel 200 and an upper surface HR2U of the second heat dissipation layer HR2 positioned on the upper surface 130U of the inner plate 130 are spaced apart by a first air gap AG1 such that the first air gap AG1 is between the first heat dissipation layer HR1 and the second heat dissipation layer HR2. As there is the first air gap AG1 between the display panel 200 and the inner plate 130, the impact applied to the display panel 200 from the outside may not be transferred to the inner plate 130 and the impact applied to the inner plate 130 from the outside may not be transferred to the display panel 200. Accordingly, it is possible to implement the display device 100 with beneficial durability. Furthermore, due to the first air gap AG1, the display panel 200 and the inner plate 130 are not in contact with each other.

The heat generated from the display panel 200 as the display device 100 is driven should be smoothly transferred to the rear or lower convection point of the display panel 200 so that the display panel 200 can release the heat to the external environment. The first air gap AG1 positioned between a lower surface 200L of the display panel 200 and an upper surface 130U of the inner plate 130 has very low thermal conductivity. When only the first air gap AG1 is positioned between the display panel 200 and the inner plate 130, the heat generated in the display panel 200 is not sufficiently transferred to the outside by the first air gap AG1. Accordingly, the cooling efficiency of the display device 100 is reduced, and the temperature of the display panel 200 may rise significantly.

In one embodiment, each of the display panel 200 and the inner plate 130 can comprise a material having an emissivity of 0.2 or less. For example, the inner plate 130 can comprise of metal material. The emissivity of a material is its ability to emit thermal radiation compared to a blackbody at the same temperature.

The radiation is determined by the temperature difference between two surfaces facing each other and the emissivity (ε). When the display panel 200 and the inner plate 130 made of the metal material with the emissivity ε of 0.2 or less face each other with the first air gap AG1 between the display panel 200 and the inner plate 130, it is difficult for the heat generated in the display panel 200 to be released to the outside through the inner plate 130.

In one embodiment, each of the first heat dissipation layer HR1 disposed on the lower surface 200L of the display panel 200 and the second heat dissipation layer HR2 disposed on the upper surface 130U of the inner plate 130 may have a thickness, but is not limited to, between about 10 µm and about 100 µm, for example, between about 10 µm and about 50 µm, respectively. When the first heat dissipation layer HR1 and the second heat dissipation layer HR2 each has the thickness between about 10 µm and about 100 µm, the heat generated in the display panel 200 can be rapidly transferred to the external environment through the first heat dissipation layer HR1, the first air gap AG1, and the second heat dissipation layer HR2.

In the present disclosure, the first heat dissipation layer HR1 and the second heat dissipation layer HR2 each of which includes a material having a beneficial or high emissivity (ε) are positioned on the lower surface 200L of the display panel 200 and the upper surface 130U of the inner plate 130, respectively, where each of the display panel 200 and the inner plate 130 has a low emissivity (ε) owing to a material such as metal. In one embodiment, each of the first heat dissipation layer HR1 and the second heat dissipation layer HR2 includes a material having an emissivity (ε) of 0.8 or more and less than 1, for example, 0.9 or more and less than 1. Thus, the emissivity of each of the first heat dissipation layer HR1 and the second heat dissipation layer HR2 is greater than the emissivity of each of the display panel 200 and the inner plate 130. In this case, heat radiation between the first heat dissipation layer HR1 and the second heat dissipation layer HR2 occurs quickly despite the low thermal conductivity of the first air gap AG1. Accordingly, the amount of heat extracted from the display panel 200 to the external environment via the inner plate 130 can increase.

The first heat dissipation layer HR1 and the second heat dissipation layer HR2, each including the material having a high emissivity (ε) relative to the emissivity of the display panel 200 and the inner plate 130, are positioned on the lower surface 200L of the display panel 200 and the upper surface 130U of the inner plate 130 facing each other, respectively. Therefore, the heat generated in the display panel 200 during the driving process can be quickly and efficiently released to the external environment through the inner plate 130. Accordingly, the cooling effect of the display device 100 can be significantly improved.

A first heat dissipation component 142 and a second heat dissipation component 144 can be positioned on an upper surface 140U and a lower surface 140L of the driving circuit board 140. Each of the first heat dissipation component 142 and the second heat dissipation component 144 can comprise a material having a high thermal conductivity. The driving circuit board 140 may have a dimension or a width smaller than a dimension or a width of the display panel 200 and the/or the inner plate 130.

A third heat dissipation layer HR3 is positioned on a lower surface 130L of the inner plate 130 in the display device 100. The third heat dissipation layer HR3 may be in contact (e.g., direct contact) with the lower surface 130L of the inner plate 130. A lower surface HR3L of the third heat dissipation layer HR3 is spaced apart from an upper surface 110U of the lower frame 110 by a second air gap AG2. The lower surface HR3L of the third heat dissipation layer HR3 can be spaced apart from the upper surface 140U of the driving circuit board 140 by the third air gap AG2-1. The lower surface 140L of the driving circuit board 140 can be spaced apart from the upper surface 110U of the lower frame 110 by a fourth air gap AG2-2. The heat generated in the driving circuit board 140 may not be transferred toward the display panel 200 because of the third air gap AG2-1 that is between the lower surface 130L of the inner plate 130 and the upper surface 140U of the driving circuit board 140.

The third heat dissipation layer HR3 disposed on the lower surface 130L of the inner plate 130 has a different component from the first heat dissipation layer HR1 and the second heat dissipation layer HR2. The third heat dissipation layer HR3 includes a first area heat dissipation layer LE disposed on a first lower surface 130L1 of the inner plate 130 that overlaps the upper surface 140U of the driving circuit board 140. In addition, the third heat dissipation layer HR3 further includes a second area dissipation layer HE disposed on a second lower surface 130L2 of the inner plate 130 that faces to the upper surface 110U of the lower frame 110 without overlapping the driving circuit board 140.

The first area heat dissipation layer LE can comprise a material having an emissivity (ε) of 0.2 or more and 0.5 or less. The second area heat dissipation layer HE can comprise a material having an emissivity (ε) of 0.8 or more and less than 1. Thus, the emissivity of the second area heat dissipation layer HE may be greater than the emissivity of the first area heat dissipation layer LE.

When the display device 100 is driven, the temperature of the driving circuit board 140 that provides various signals to the display panel 200 rises rapidly. The driving circuit board 140 is spaced part from the first area heat dissipation layer LE acting as an insulation layer by the third air gap AG2-1. The first area heat dissipation layer LE placed on the first lower surface 130L1 of the inner plate 130 that overlaps the driving circuit board 140 comprises the material with low emissivity (ε) relative to the second area heat dissipation layer HE.

The heat generated in the driving circuit board 140 radiates little (e.g., negligible heat) to the first area heat dissipation layer LE. Accordingly, the heat generated in the driving circuit board 140 is minimally transferred to the inner plate 130 and the display panel 200, thereby preventing the light-emitting diode D inside the display panel 200 from being deteriorated.

On the contrary, the second area heat dissipation layer HE including the material with high emissivity (ε) is placed on the second lower surface 130L2 of the inner plate 130 facing to the upper surface 110U of the lower frame 110. Accordingly, the heat generated in the display panel 200 can be efficiently transferred to the external environment through the first heat dissipation layer HR1, the second heat dissipation layer HR2, and the second area heat dissipation layer HE among the third heat dissipation layer HR3 each of which includes the material having high emissivity (ε).

The first heat dissipation layer HR1, the second heat dissipation layer HR2, and the second area heat dissipation layer HE of the third heat dissipation layer HR3 can be placed on the lower surface 200L of the display panel 200, the upper surface 130U of the inner plate 130, and the second lower surface 130L2 of the inner plate 130, respectively, by a coating process or a deposition process.

For example, a component for forming the first heat dissipation layer HR1, the second heat dissipation layer HR2 and the second area heat dissipation layer HE, for example, a component where a paint or an inorganic material with the emissivity (ε) of 0.8 or more and less than 1 is dispersed in at least one solvent, can be coated on the lower surface 200L of the display panel 200, the upper surface 130U of the inner plate 130 and the second lower surface 130L2 of the inner plate 130 facing to the upper surface 110U of the lower frame 100, respectively, and then that component can be cured by heat treatment, if necessary.

In one embodiment, each of the first heat dissipation layer HR1, the second heat dissipation layer HR2 and the second area heat dissipation layer HE can independently comprise a material selected from, but is not limited to, graphite, graphene, carbon nanotube (CNT), formica, glass, iron, paint, an acryl-containing resin, a black resin, polypropylene, a rubber, quartz, an insulating tape, a varnish, silicon nitride (SiNₓ, where 0 < x ≤ 2), a carbon pigment, Inconel, and combinations thereof.

The first area heat dissipation layer LE can comprise a material having high heat conductivity. As an example, the first area heat dissipation layer LE can comprise, but is not limited to, a metal component selected from aluminum, zinc, tin, tungsten, iron, steel, copper, cobalt, nickel, electrogalvanized iron (EGI), stainless steel and combinations thereof. For example, the first area heat dissipation layer LE can be disposed on the first lower surface 130L1 of the inner plate 130 corresponding to the upper surface 140U of the driving circuit board 140 by a deposition process.

In the first embodiment, the first heat dissipation layer HR1, the second heat dissipation layer HR2 and the second area heat dissipation layer HE with high emissivity (ε) are placed on the lower surface 200L of the display panel 200, the upper surface 130U of the inner plate 130 and the second lower surface 130L2 of the inner plate 130 facing to the lower frame 110, respectively. The first area heat dissipation layer LE with low emissivity (ε) is placed on the first lower surface 130L1 of the inner plate 130 corresponding to the driving circuit board 140. Two heat dissipation layers HR1 and HR2 are faced to each other on the lower surface 200L of the display panel 200 and the upper surface 130U of the inner plate 130. The heat generated in the display panel 200 when the display device 100 is driven can be released to the outside through the inner plate 130.

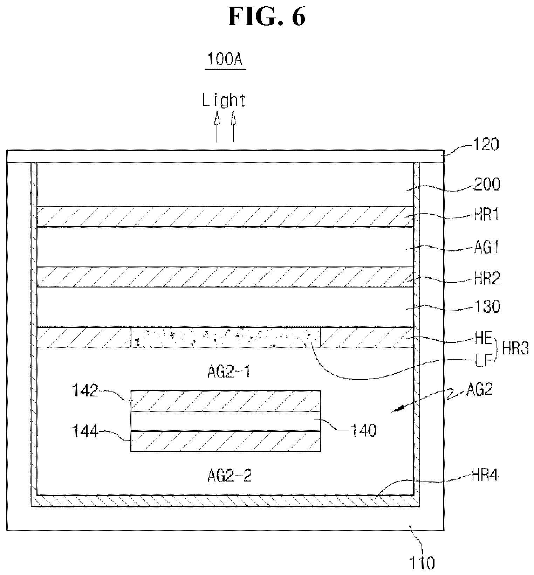

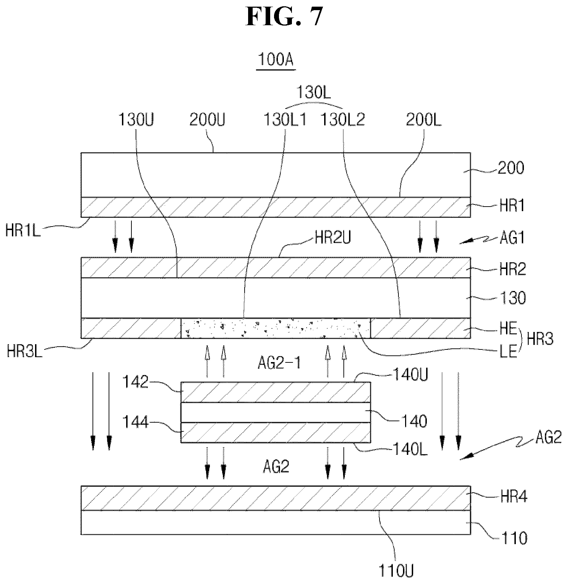

FIG. 6 illustrates a schematic cross-sectional view of the display device in accordance with a second embodiment of the present disclosure. FIG. 7 is a schematic diagram illustrating that heat generated when the display device is driven is released toward the outside in accordance with the second embodiment of the present disclosure.

As illustrated in FIGS. 6 and 7, the display device 100A in accordance with the second embodiment includes a fourth heat dissipation layer HR4 on the upper surface 110U of the lower frame 110 compared to the first embodiment in FIGS. 4 and 5.

The fourth heat dissipation layer HR4 can comprise a material having emissivity (ε) of about 0.8 or more and less than 1. The fourth heat dissipation layer HR4 can be placed on the upper surface 110U of the lower frame 110 using the same process as the first heat dissipation layer HR1, the second heat dissipation layer HR2 and the second area heat dissipation layer HE of the third heat dissipation layer HR3. The fourth heat dissipation layer HR4 can comprise, but is not limited to, a material selected from, but is not limited to, graphite, graphene, carbon nanotube (CNT), formica, glass, iron, paint, an acryl-containing resin, a black resin, polypropylene, a rubber, quartz, an insulating tape, a varnish, silicon nitride (SiNₓ, where 0 < x ≤ 2), a carbon pigment, Inconel, and combinations thereof.

The first heat dissipation layer HR1 and the second heat dissipation layer HR2 with high emissivity (ε) are placed on the lower surface 200L of the display panel 200 and the upper surface 130U of the inner plate 130 facing to each other, respectively. The heat generated in the display panel 200 can be quickly released toward the inner plate 130. Also, the second area heat dissipation layer HE and the fourth heat dissipation layer HR4 with high emissivity (ε) are placed on the second lower surface 130L2 of the inner plate 130 and the upper surface 110U of the lower frame 110 facing to each other, respectively. In one embodiment, ends of the first heat dissipation layer HR1, ends of the second heat dissipation layer HR2, and ends of the second area heat dissipation layer HE are in direct contact with the fourth heat dissipation layer HR4. The heat transferred from the display panel 200 can be released quickly to the external environment from the inner plate 130 through the lower frame 110.

In addition, the first area heat dissipation layer LE including the material with low emissivity (ε) is placed on the first lower surface 130L1 of the inner plate 130 that overlaps the upper surface 140U of the driving circuit board 140. The heat transfer to the inner plate 130 and the display panel 200 from the driving circuit board 140 can be minimized or at least reduced owing to the first area heat dissipation layer LE having low emissivity (ε).

Compared to the first embodiment, the display device 100A further includes the fourth heat dissipation layer HR4 with high emissivity (ε) placed on the upper surface 100U of the lower frame 110 such that a portion of the fourth heat dissipation layer HR4 is between the upper surface of the lower frame 110 and the driving circuit board 140. As the second area heat dissipation layer HE and the fourth heat dissipation layer HR4 with high emissivity (ε) are placed on the second lower surface 130L2 of the inner plate 130 and the upper surface 110U of the lower frame 110 facing to each other, respectively, the heat radiation toward the lower frame 130 from the inner plate 110 can be further improved. Therefore, the heat generated in the display panel 200 can be much efficiently released toward the external environment. In addition, it is possible to efficiently reduce the heat amount transferred to the display panel 200 from the driving circuit board 140.

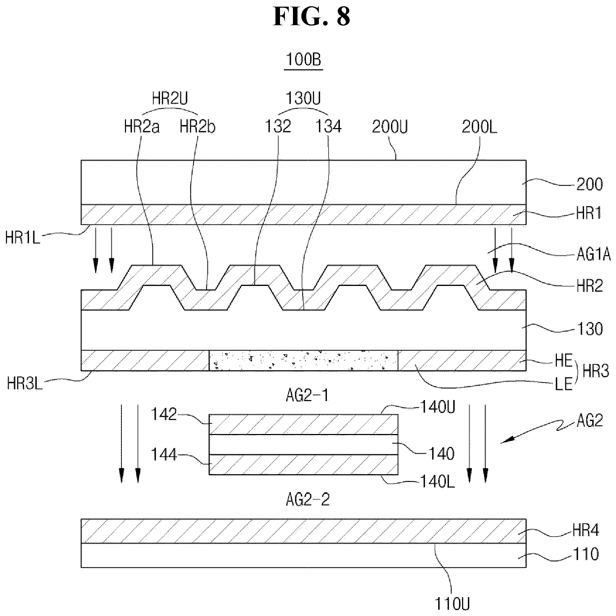

FIG. 8 illustrates a schematic cross-sectional view of the display device in accordance with a third embodiment of the present disclosure.

As illustrated in FIG. 8, the display device 100B in the third embodiment includes a plurality of first uneven structures 132 and 134 on the upper surface 130U of the inner plate that is spaced apart from the lower surface 200L of the display panel 200. The upper surface 130U of the inner plate 130 includes a plurality of first convex portions or first protruding portions 132 protruding toward the display panel 200 and a plurality of first concave portions 134 arranged between the plurality of the first convex portions 132 that protrude away from the display panel 200 toward the inner plate 130. In this case, the upper surface HR2U of the second heat dissipation layer HR2 may have a plurality of uneven patterns HR2a and HR2b corresponding to the plurality of the first convex portions 132 and the plurality of the first concave portions 134 located on the upper surface 130U of the inner plate 130.

In FIG. 8, each of the first convex portions 132 has a trapezoidal cross-section, and each of the first concave portions 134 has an inverse trapezoidal cross-section, but is not limited thereto. In another embodiment, each of the first convex portions 132 and each of the first concave portions 134 can have a square-shaped cross-section and/or a gear-shaped cross-section.

In another embodiment, each of the first convex portions 132 and the first concave portions 134 located on the upper surface 130U of the inner plate 130 can have a corrugation or an irregular structure of configuration. The surface area of the second heat dissipation layer HR2 with the uneven patterns HR2a and HR2b corresponding to the first uneven structures 132 and 134 increases, and the first air gap AG1A between the first heat dissipation layer HR1 and the second heat dissipation layer HR2 on which the first convex portions 132 are located is decreased. As the heat transfer to the inner plate 130 from the display panel 200 increases, the heat radiation amount released toward the lower surface 200L of the display panel 200 increases. Accordingly, the amount of heat extraction to the external environment is further improved, and the cooling effect in the display device 100B can be maximized.

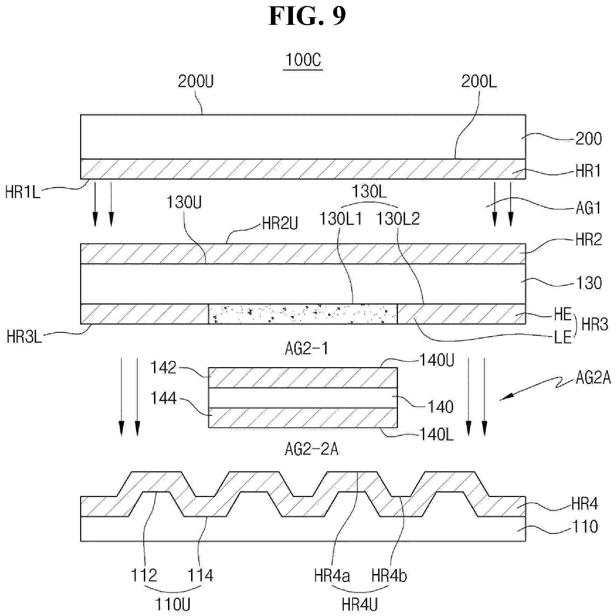

FIG. 9 illustrates a schematic cross-sectional view of the display device in accordance with a fourth embodiment of the present disclosure.

As illustrated in FIG. 9, the display device 100C in the fourth embodiment includes a plurality of second uneven structures 112 and 114 on the upper surface 110U of the lower frame 110 disposed under the display panel 200 and the inner plate 130. The upper surface 110U of the lower frame 110 includes a plurality of second convex portions or second protruding portions 112 protruding toward the inner plate 130 and a plurality of second concave portions 114 arranged between the plurality of the second convex portions 112 that protrude away from the inner plate 130 toward the lower frame 110. In this case, an upper surface HR4U of the fourth heat dissipation layer HR4 may have a plurality of uneven patterns HR4a and HR4b corresponding to the plurality of the second convex portions 112 and the plurality of the second concave portions 114 located on the upper surface 110U of the lower frame 110.

In FIG. 9, each of the second convex portions 112 has a trapezoidal cross-section, and each of the second concave portions 112 has an inverse trapezoidal cross-section, but is not limited thereto. In another embodiment, each of the second convex portions 112 and each of the second concave portions 114 can have a square-shaped cross-section and/or a gear-shaped cross-section.

In another embodiment, each of the second convex portions 112 and the second concave portions 114 located on the upper surface 110U of the lower frame 110 can have a corrugation or an irregular structure of configuration. The surface area of the fourth heat dissipation layer HR4 with the uneven patterns HR4a and HR4b corresponding to the second uneven structures 112 and 114 increases, and the second air gap AG2A between the second area heat dissipation layer HE disposed on the second lower surface 130L of the inner plate 130 and the upper surface HR4U of the fourth heat dissipation layer HR4 on which the second convex portions 112 are located is decreased.

As the heat transfer to lower frame 110 via the inner plate 130 from the display panel 200 increases, the heat radiation amount released toward the lower surface 200L of the display panel 200 increases. Accordingly, the amount of heat extraction to the external environment is further improved, and the cooling effect in the display device 100B can be maximized.

In another embodiment, the first uneven structure having the plurality of first convex portions 132 (FIG. 8) and the plurality of second concave portions 134 (FIG. 8) between the first convex portions 132 is located on the upper surface 130U of the inner plate 130, and the second uneven structure having the plurality of second convex portions 112 and the plurality of second concave portions 112 is located on the upper surface 110U of the lower frame 110.

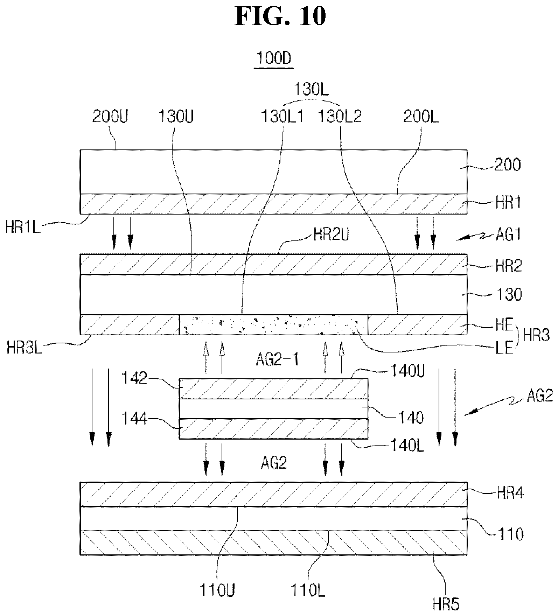

FIG. 10 illustrates a schematic cross-sectional view of the display device in accordance with a fifth embodiment of the present disclosure.

As illustrated in FIG. 10, the display device 100D in the fourth embodiment further includes a fifth heat dissipation layer HR5 disposed on a lower surface 110L of the lower frame 110 in addition to the fourth heat dissipation layer HR4 disposed on the upper surface 110U of the lower frame 110, compared to the display device 100A in the second embodiment.

The fourth heat dissipation layer HR4 comprises a material having emissivity (ε) of about 0.8 or more and less than 1. The fourth heat dissipation layer HR4 can comprise a same material as the material in the first heat dissipation layer HR1, the second heat dissipation layer HR3 and the second area heat dissipation layer HE. The fourth heat dissipation layer HR4 can be attached to the upper surface 110U of the lower frame 110 by the coating process or the deposition process. In certain embodiments, the fourth heat dissipation layer HR4 can be omitted.

In an exemplary embodiment, the lower frame 110 can comprise a material having emissivity (ε) of about 0.2 or more and about 0.6 or less. As an example, the lower frame 110 can comprise a metal component. For example, the metal component of the lower frame 110 can comprise, but is not limited to, aluminum, zinc, tin, tungsten, iron, steel, copper, cobalt, nickel, electrogalvanized iron (EGI), stainless steel and combinations thereof.

In an exemplary embodiment, the fifth heat dissipation layer HR5 can comprise a material having emissivity (ε) of 0.8 or more and less than 1. Thus, the emissivity of the fifth heat dissipation layer HR5 is greater than the emissivity of the lower frame 110. For example, the fifth heat dissipation layer HR5 can comprise a same material as the material in the first heat dissipation layer HR1, the second heat dissipation layer HR3 and the second area heat dissipation layer HE.

In another embodiment, the fifth heat dissipation layer HR5 can comprise a polymer having high emissivity (ε), for example, about 0.6 or more and less than 1. The polymer of the fifth heat dissipation layer HR5 can comprise a transparent polymer. For example, the polymer of the fifth heat dissipation layer HR5 can comprise, but is not limited to, polydiemthyl siloxane (PDMS), polymethyl methacrylate (PMMA), polyethylene terephthalate (PET), polycarbonate (PC), polyurethane (PU), an ethylene vinyl acetate copolymer (EVA), cellulose acetate, copolymers thereof and/or combinations thereof. As an example, the fifth heat dissipation layer HR5 can be attached to the lower surface 110L of the lower frame 110 by the coating process.

In the fifth embodiment, the fifth heat dissipation layer HR5 including the high emissivity (ε) material is disposed on the lower surface 110L of the lower frame 110 that is positioned at the outermost side of the display device 100D. The lower frame 110 comprises the metal component having lower emissivity (ε), and the fifth heat dissipation layer HR5 including the material (e.g. polymer) having relatively high emissivity (ε) is attached to the lower surface 100L of the lower frame 100. As the fifth heat dissipation layer HR5 is transparent to visible light, the visible light can be reflected from the lower frame 110 and infrared light can be released to the external environment.

In the fifth embodiment, it possible to implement passive daytime radiative cooling (PDRC) by disposing the fifth heat dissipation layer HR5 having relatively high emissivity (ε) on the lower surface 110L of the lower frame 110. Therefore, it is possible to cool efficiently the display device 100D in the day time when strong light is irradiated in accordance with the fifth embodiment.

Hereinafter, the present disclosure is described in more detail through the exemplary examples, but the present disclosure is not limited to the following examples.

### [Example 1] Temperature Change in Display Device having High Emissivity

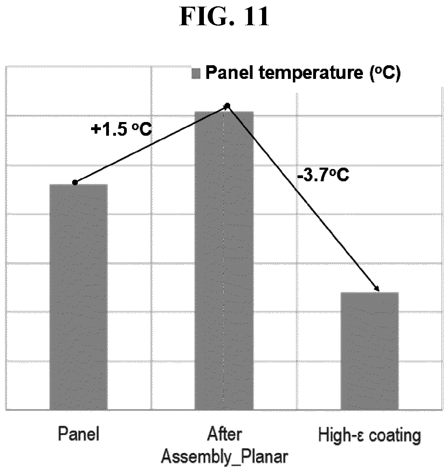

A heat dissipation layer made of a material having an emissivity (ε) of 0.9 was placed on the lower surface of the display panel, the upper surface and the lower surface of the inner plate facing the display panel and spaced apart from the display panel, the upper surface of the lower frame (cover bottom) facing the inner plate and spaced apart from the inner plate. A display device was manufactured by assembling the display panel, the inner plate and the lower frame, and then the panel temperature was evaluated. For comparison, a display device without the heat dissipation layer was used. The evaluation results are illustrated in FIG. 11. In the display device assembled only with the display panel, the inner plate and the lower frame with low emissivity without arranging the heat dissipation layer, the thermal conductivity decreased and the front temperature of the display panel increased by 1.5°C. On the other hand, in the display device in which the heat dissipation layer of the high-emissivity material is arranged on the lower surface of the display panel, the upper and lower surfaces of the inner plate and the upper surface of the lower frame, the heat energy in the form of radiation is efficiently transferred to the external environment, thereby improving the cooling effect, and the panel temperature is reduced by 3.7°C.

### [Example 2] Panel Temperature Change of Display Device with High Emissivity

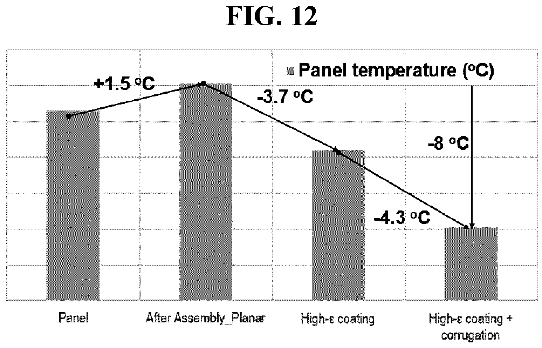

The temperature change of the display panel in the display device applying a corrugation or irregular structure having a plurality of protrusions and concave portions between the protrusions on the upper surface of the inner plate or the upper surface of the lower frame, In addition to arranging the heat dissipation panel with high emissivity on the lower surface of the display panel, the upper and lower surfaces of the inner plate and the upper surface of the lower frame, was evaluated. The evaluation results are illustrated in FIG. 12, when the corrugation structure was applied, the panel temperature was further reduced by 4.3°C compared to the display device manufacture in Example 1, and the panel temperature was reduced by 8°C compared to the display device manufactured in comparative examples in which the heat dissipation layer was not applied, and confirmed that the cooling effect was maximized.

Also disclosed are the following numbered clauses:
1. A display device, comprising: a display panel including a first surface at which an image is displayed and a second surface that is opposite the first surface; a plate including a first surface and a second surface, the first surface of the plate spaced apart from the second surface of the display panel by a first airgap; a frame that is spaced apart from the second surface of the plate; a driving circuit board that is between the second surface of the plate and the frame; a first heat dissipation layer in contact with the second surface of the display panel; a second heat dissipation layer in contact with the first surface of the plate such that the first airgap is between the first heat dissipation layer and the second heat dissipation layer; and a third heat dissipation layer in contact with the second surface of the plate, the third heat dissipation layer having a first area heat dissipation layer that overlaps the driving circuit board and a second area heat dissipation layer that is non-overlapping with the driving circuit board, wherein an emissivity of the first heat dissipation layer and an emissivity of the second heat dissipation layer are greater than an emissivity of the display panel and an emissivity of the plate, wherein an emissivity of the first area heat dissipation layer is less than an emissivity of the second area heat dissipation layer.
2. The display device of clause 1, wherein the frame includes a first surface and a second surface that is opposite the first surface, and the display device further comprises: a fourth heat dissipation layer on the first surface of the frame, wherein a portion of the fourth heat dissipation layer is between the first surface of the frame and the driving circuit board.
3. The display device of clause 1 or 2, wherein the first surface of the plate includes a plurality of convex portions protruding toward the display panel and a plurality of concave portions positioned between the plurality of convex portions that protrude away from the display panel, wherein the second heat dissipation layer has a shape that corresponds to the plurality of convex portions and the plurality of concave portions of the first surface of the plate.
4. The display device of clause 2 or 3, wherein the first surface of the frame includes a plurality of convex portions protruding toward the plate and a plurality of concave portions positioned between the plurality of convex portions and protrude away from the plate, wherein the fourth heat dissipation layer has a shape that corresponds to the plurality of convex portions and the plurality of concave portions of the first surface of the frame.

It will be apparent to those skilled in the art that various modifications and variations can be made in the present disclosure without departing from the scope of the disclosure. Thus, it is intended that the present disclosure cover the modifications and variations of the present disclosure provided they come within the scope of the appended claims.

## Claims

1. A display device (100), comprising:
a display panel (200) including a first surface at which an image is displayed and a second surface that is opposite the first surface;
an inner plate (130) including a first surface that is spaced apart from the second surface of the display panel and a second surface;
a lower frame (110) that is spaced apart from the second surface of the inner plate;
a driving circuit board (140) that is between the second surface of the inner plate and the lower frame;
a first heat dissipation layer (HR1) on the second surface of the display panel;
a second heat dissipation layer (HR2) on the first surface of the inner plate such that the second heat dissipation layer is between the first heat dissipation layer and the first surface of the inner plate; and
a third heat dissipation layer (HR3) disposed on the second surface of the inner plate,
wherein the third heat dissipation layer includes a first area heat dissipation layer (LE) that overlaps the driving circuit board and a second area heat dissipation layer (HE) that is non-overlapping with the driving circuit board,
wherein each of the first heat dissipation layer, the second heat dissipation layer, and the second area heat dissipation layer each includes a material having an emissivity of 0.8 or more and less than 1, and
wherein the first area heat dissipation layer includes a material having an emissivity between 0.2 and 0.5.

2. The display device of claim 1, wherein the lower frame includes a first surface and a second surface that is opposite the first surface, and the display device further comprises:
a fourth heat dissipation layer (HR4) on the first surface of the lower frame,
wherein a portion of the fourth heat dissipation layer is between the first surface of the lower frame and the driving circuit board.

3. The display device of claim 2, wherein the fourth heat dissipation layer includes a material having an emissivity of 0.8 or more and less than 1.

4. The display device of claim 2 or 3, wherein the display device further comprises:
a fifth heat dissipation layer (HR5) on the second surface of the lower frame.

5. The display device of claim 4, wherein the lower frame includes a material having an emissivity between 0.2 and 0.6.

6. The display device of claim 5, wherein the fifth heat dissipation layer includes a material having an emissivity of 0.8 or more and less than 1.

7. The display device of claim 5, wherein a metal component of the first area heat dissipation layer and/or lower frame comprises one of aluminum, zinc, tin, tungsten, iron, steel, copper, cobalt, nickel, electrogalvanized iron "EGI", stainless steel, or combinations thereof.

8. The display device of claim 5, 6 or 7, wherein the fifth heat dissipation layer includes a polymer, and optionally wherein the polymer is one of polydimethyl siloxane "PDMS", polymethyl methacrylate "PMMA", polyethylene terephthalate "PET", polycarbonate "PC", polyurethane "PU", ethylene-vinyl acetate copolymer "EVA", cellulose acetate, copolymers thereof, or combinations thereof.

9. The display device of any preceding claim, wherein the first surface of the inner plate includes a plurality of convex portions protruding toward the display panel and a plurality of concave portions positioned between the plurality of convex portions that protrude away from the display panel.

10. The display device of claim 9, wherein each of the plurality of convex portions and the plurality of concave portions located on the first surface of the inner plate has a corrugated structure.

11. The display device of claim 1, wherein the lower frame includes a first surface and a second surface that is opposite the first surface, and the first surface of the lower frame includes a plurality of convex portions protruding toward the inner plate and a plurality of concave portions positioned between the plurality of convex portions and protrude away from the inner plate.

12. The display device of claim 11, wherein each of the plurality of convex portions and the plurality of concave portions located on the first surface of the lower frame has a corrugated structure.

13. The display device of claim 12, wherein the display device further comprises:
a fourth heat-dissipation layer (HR4) on the first surface of the lower frame,
wherein the fourth heat-dissipation layer (HR) has an uneven shape corresponding to the plurality of convex portions and the plurality of concave portions.

14. The display device of any preceding claim, wherein the display panel is spaced apart from the inner plate with a first air gap (AG1) between the display panel and the inner plate, and the inner plate is spaced part from the lower frame with a second air gap (AG2) between the inner plate and the lower frame.

15. The display device of any preceding claim, wherein each of the first heat dissipation layer, the second heat dissipation layer, and the second area heat dissipation layer includes graphite, graphene, carbon nanotube "CNT", formica, glass, iron, paint, an acryl-containing resin, a black resin, polypropylene, rubber, quartz, an insulating tape, a varnish, silicon nitride, a carbon pigment, Inconel, or combinations thereof.
